Europäisches Patentamt

(19) European Patent Office

Office européen des brevets

(11) Publication number: 0 117 217
A1

(12) EUROPEAN PATENT APPLICATION

(21) Application number: 84630015.0

(22) Date of filing: 03.02.84

(51) Int. Cl.³: F 16 B 21/02
H 05 K 7/00

(30) Priority: 18.02.83 US 467986

(43) Date of publication of application:
29.08.84 Bulletin 84/35

(84) Designated Contracting States:
BE DE FR GB NL

(71) Applicant: REXNORD INC.
P.O. Box 2022
Milwaukee, Wisconsin 53201(US)

(72) Inventor: Colgan, William L.
48 Burma Road
Wyckoff New Jersey 07481(US)

(74) Representative: Weydert, Robert et al,
Office Dennemeyer S.à.r.l. 21-25 Allée Scheffer P.O. Box
41
L-2010 Luxembourg(LU)

(54) Fast-acting bi-directional positive drive fastener assembly.

(57) A fast-acting bi-directional positive drive fastener assembly includes a receptacle (16) having a cylindrical member (17) having a helical slot (31) therein on which the cross-pin (21) of a stud (18) may move axially and rotatably in response to rotational movement imparted to the stud (18).

FIG. 1

Croydon Printing Company Ltd.

## FAST-ACTING BI-DIRECTIONAL POSITIVE DRIVE FASTENER ASSEMBLY

The present invention relates to a fastener assembly used to connect a movable member to a frame and, more particularly, to an improved fast acting, bi-directional, positive drive fastener assembly used for inserting and removing printed circuit boards from a chassis.

Fasteners of the type with which the present invention is concerned provide a quick operating high re-use mechanical fastening system. Typically such fasteners include a receptacle secured to a frame member and a stud assembly which can be inserted through a movable panel member and secured to the receptacle. Fast acting fasteners of this type generally have a built-in quick operating cam in the end of the receptacle remote from the frame and a cross-pin in the mating stud assembly, and are commonly referred to as quarter-turn fasteners. The cross-pin acts as a cam follower, and when the stud assembly is rotated, the stud cross-pin rides up the cam causing a preload to be applied to the joint.

Spring means are typically mounted on the stud to provide the preload force tending to move the stud away from the receptacle thereby securing the stud in the receptacle.

Further, the receptacles are generally secured to the frame by means of a cage which in turn is secured to the frame by means of two rivets, each of which passes through an aperture in flange members of the cage.

These types of fasteners are generally quite acceptable, however, in certain applications several drawbacks become apparent. One such application is when fasteners of this type are used to secure printed circuit boards. Usually these boards have electrical connector pins which engage electrical sockets. Care must therefore be taken upon engagement and disengagement of the fasteners to avoid bending the connector pins. Existing fasteners provide no positive driving force during disengagement, so removal of the electrical connectors from their respective sockets is accomplished manually, that is, by pulling the board from the socket. This increases the possibility of damaging the connectors during engagement and disengagement.

Further, existing cage and flange members present unusually large and complicated metallic surface areas which are difficult to fasten to narrow printed circuit boards.

-2-

Still further, existing receptacles must be braced with gussets or webs to increase their strength and rigidity, which increases their weight and cost.

One object of the present invention is to provide a fastener assembly that provides a positive drive during both engagement and disengagement of the fastener.

Another object of the present invention is to provide a one-piece receptacle having integral rivets and free from flanges with apertures therein.

Still another object of the present invention is to provide a fastener assembly that is economical and simple to manufacture, whether it is machined or die-cast.

The fastener assembly of the present invention accomplishes this and other objects that will become apparent by providing a unitary, generally right cylindrical receptacle that has integral rivets and two sets of opposed gradual ramps through the wall of the cylindrical receptacle body in which the cross-pin of the stud travels during both engagement and disengagement. Preferably, the ramp defines a helix having its axis coincident with the longitudinal axis of the receptacle upon which the cross-pin of the stud rides for engagement or disengagement in response to rotation of the stud. The angle of rotation of the stud is dependent upon the pitch of the helix.

The various features of novelty which characterize the invention are pointed out with particularity in the claims annexed to and forming a part of this specification. For a better understanding of the invention, its operating advantages and specific objects attained by its use, reference should be had to the accompanying drawings and descriptive matters in which there is illustrated and described a preferred embodiment of the invention.

A more thorough understanding of the present invention will be gained by reading the following description of the preferred embodiments with reference to the accompanying drawings in which:

Figure 1 is an elevation view partly broken away and partly in section of a fastener assembly constructed according to the principals of the present invention,

Figure 2 is an elevation view of a receptacle constructed according to the principals of the present inventions, and

Figure 3 is a plan view of the receptacle taken along lines 3-3 of Figure 2.

Figure 4 is a perspective view of the fastener assembly of Figure 1.

Figure 5 is a perspective view of an electronic chassis and printed circuit board incorporating a fastener assembly made in accordance with the invention.

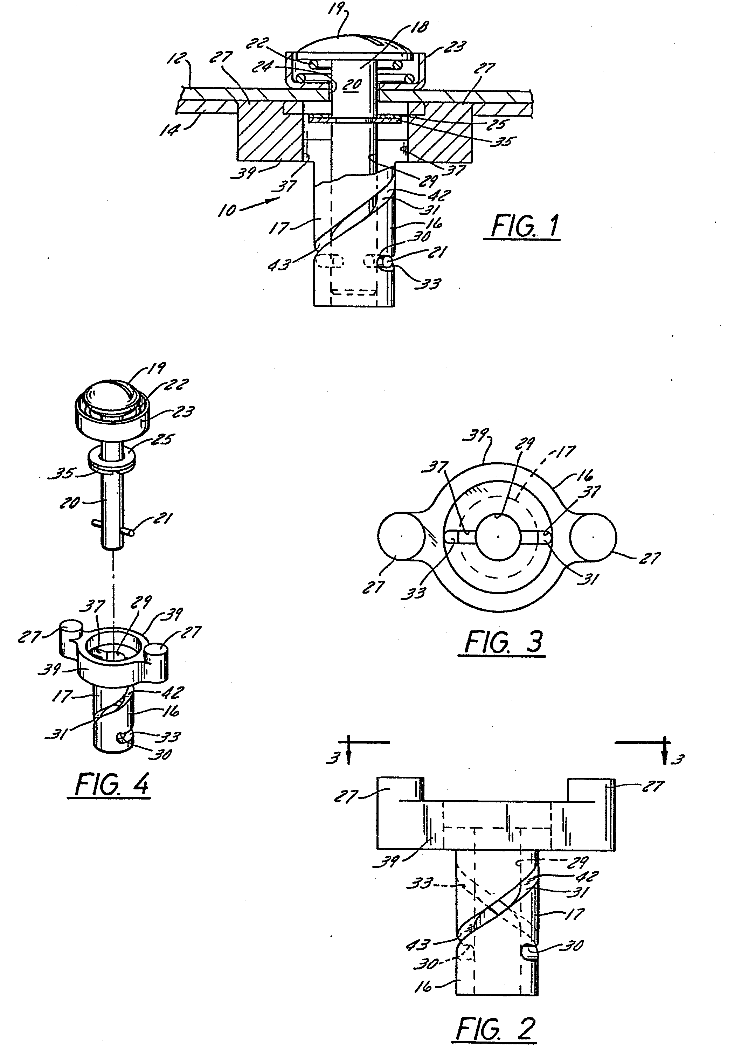

Referring now to Figure 1, there is shown a fastener assembly 10 embodying the features of the present invention. The fastener assembly 10 is used to releasably connect a panel member 12, such as a printed circuit board, with a frame member 14. As shown in the drawing, the fastener assembly includes a stud 18 and a receptacle 16.

The stud comprises a head portion 19 and a shank portion 20 extending therefrom. The shank 20 extends from the head 19 for a distance less than the combined length of the receptacle 16, frame 14 and panel 12 and terminates by having a cross-pin 21 longitudinally extending through the shank 20. The head portion 19 together with encapsulation means 23, forms a space into which spring 22 may be positioned to exert a force away from the panel 12 on the head portion 19. Preferably, a retaining ring 25 and a snap ring 35 are positioned in a groove around the shank 20 between the cross-pin 21 and the head portion 19 to retain the stud 18 with the panel or P.C. board 12 upon disengagement of the stud 18 from the receptacle 16 of the frame member of chassis 14.

The receptacle 16 defines a generally right cylindrical member 17 having a circular base member 39 with rivets 27 attached thereto, forming an integral attachment means with the base 39, for attachment to the frame member 14. The receptacle 16 is axially aligned with the stud 18 so that upon passage through the hole 24 in the panel 12 the shank 20 of the stud 18 fits into the internal bore 29 of the receptacle 16. The receptacle 16 includes axial grooves 37 for initially receiving the cross-pin 21 to help guide the stud into the receptacle.

Figure 2 shows the receptacle 16 having its cylindrical member 17 with a helical slot 31 on which the cross-pin 21 of the stud 18 rides during both engagement and disengagement of the stud 18. The embodiment shown in figure 2 shows the cylindrical member 17 of the receptacle 16 as having two helical slots, 31, 33. This configuration allows each end of the cross-pin 21, which extends beyond the shank 20, to ride on its own helical slot 31 or 33.

In order to retain as much of the fast-acting qualities associated with similar fasteners of this type and still provide positive drive during engagement and disengagement, the pitch of the helical slots 31, 33 should be greater than that of a common threaded fastener but not so great as to require excessive axial force applied to the stud 18 during engagement and disengagement of the assembly 10.

Preferably, each helix initiates at radially opposite points of the cylindrical member 17 and terminates at a point axially removed from and radially different than the initiating point in two detents 30. It can be seen that the cross-pin 21 approaches the distal end of the helical slots 31, 33 it may be rotated to rest in detent 30. In this position the fastener is locked as the spring 22 urges the stud 18 away from the receptacle 16, thereby retaining the cross-pin in the detent 30. This particular configuration has been found to provide adequate positive drive during both engagement and disengagement while retaining the fast acting qualities of similar fastener assemblies not having helical slots 31, 33.

Figure 3 shows a plan view of the receptacle 16 with the helical slots 31, 33 beginning in axial grooves 37. It can be seen that the cross-pin 21, upon being inserted in the base 39, will engage the axial grooves 37 with only a quarter turn of the stud 18.

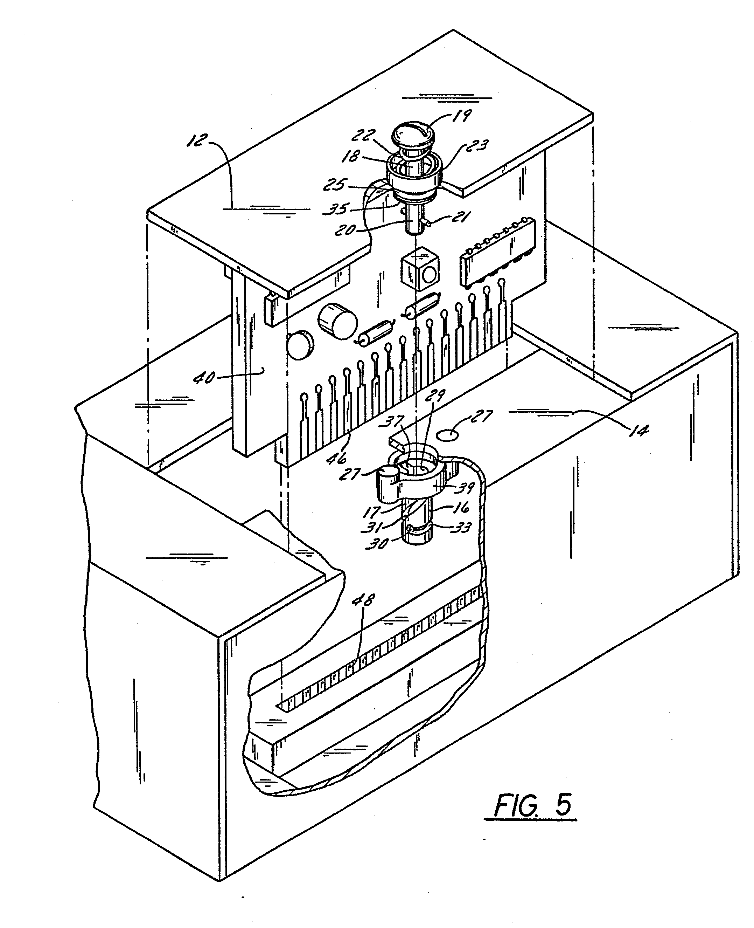

Figures 4 and 5 illustrate a fastener assembly constructed in accordance with a preferred embodiment of the invention. The helical slots 31, 33 have camming surface 42 which engage the cross-pin 21 during removal of the printed circuit board 40, and have camming surface 43 which engage the cross-pin 21 during insertion of the P.C. board 40. The camming surfaces 42 and 43 are generally of equal width since the wall of the receptacle is of uniform thickness, thus insuring that the P.C. board is moved only in the axial direction to prevent damage to the electrical pins 46 and electrical socket 48.

0117217

It will be readily understood that due to the helical slots 31, 33 on the internal bore 29 of the receptacle 16, the stud 18 is positively driven during both engagement and disengagement of the fastener assembly 10. The cross-pin 21 is retained within the helical slots 31, 33 to provide the positive drive in both directions.

There is thus provided a fastener assembly 10 that provides positive drive during both engagement and disengagement while retaining substantially all of the fast acting qualities of known fasteners of this type which do not provide positive drive during disengagement of the assembly.

CLAIMS:

1.      A fast-acting bi-directional positive drive fastener assembly comprising:

a generally cylindrical receptacle having a hollow body with an internal bore therethrough, the wall of the hollow body having a helical slot therethrough along a portion of the axial length of said receptacle; said helical slot initiating at a point near one axial end of said bore and terminating at a second point near the other axial end of said bore, and further having a detent at the terminating end of said helical slot; said wall of the hollow body being of generally equal thickness along the entire axial length of provide a uniform cam surface, and

a stud including a head portion, a shank extending from said head with a cross-pin positioned near the end of said shank remote from said head; said stud being dimensioned to move axially and rotatably in said internal bore when said cross-pin moves along said helical slot in said receptacle in response to rotational movement imparted to the head of said stud; said cross-pin being dimensioned further to rest in said detent, and spring means operatively connected to said shank to urge said stud into disengagement with said receptacle.

2.      A fast acting positive drive fastener assembly as defined in claim 1 further comprising a second helical ramp defined by said internal bore through said receptacle.

3.      A fast acting positive drive assembly as defined in claim 1 further comprising a flange means including an integral rivet means for securing said receptacle to a rigid frame.

4.      In an electronic chassis having a plurality of insertable printed circuit boards and at least one fast acting bi-directional positive drive fastener assembly for removably securing the printed circuit board in the chassis, the improvements comprising:

A generally right cylindrical receptacle having a hollow body with an internal bore therethrough, at least one helical slot through the wall of said receptacle body and a flange means with an integral rivet means for securing said receptacle to the electronic chassis, said wall being generally the same thickness throughout the entire axial length of said body to provide camming surfaces of uniform width, said helical slot initiating at a proximal point near one axial end of said bore and terminating in a detent means at a second point near the distal end of the axial bore; and

a stud including a head portion, a shank extending from said head with a cross-pin positioned near the end of said shank remote from said head, said stud being dimensioned to move axially and rotatably in said internal bore when said cross-pin moves along said camming surfaces of said helical slot in said receptacle in response to rotational movement imparted to said head portion of said stud, said cross-pin being dimensioned further to rest in said detent means, and spring means operatively connected to said shank to urge said stud into disengagement with said receptacle.

FIG. 1

FIG. 3

FIG. 4

FIG. 2

0117217

2 / 2

FIG. 5

European Patent Office

**EUROPEAN SEARCH REPORT**

0117217
Application number

| Category | Citation of document with indication, where appropriate, of relevant passages | Relevant to claim | CLASSIFICATION OF THE APPLICATION (Int. Cl. ³) |
|---|---|---|---|
| | **DOCUMENTS CONSIDERED TO BE RELEVANT** | | EP 84630015.0 |
| A | DE - A1 - 2 817 251 (REXNORD INC.) <br> * Claim 1; fig. 1-3 * <br> -- | 1 | F 16 B 21/02 <br> H 05 K 7/00 |
| A | E. NESPER "Der Radio-Amateur", 4th edition, 1924 <br> JULIUS SPRINGER, Berlin <br> * Pages 276-277, especially fig. 262 * <br> ---- | 1 | |
| | | | **TECHNICAL FIELDS SEARCHED (Int. Cl. ³)** <br><br> F 16 B <br> H 05 K |

The present search report has been drawn up for all claims

| Place of search <br> VIENNA | Date of completion of the search <br> 02-05-1984 | Examiner <br> REIF |
|---|---|---|

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503. 03.82